# EUROPEAN PATENT APPLICATION

(11) **EP 4 459 391 A1**
(43) Date of publication of application: **06.11.2024**
(21) Application number: 24173447.4
(22) Date of filing: 30.04.2024
(51) Int. Cl.: G05B 15/02, G08B 21/22, H04L 12/28, H04L 67/54

(54) **SYSTEM FOR CONTROLLING A SMART HOME AND METHOD FOR CONTROLLING A SMART HOME**

(30) Priority: 30.04.2023 PL 44471423
(71) Applicant: Vemmio SP. Z O.O., 41-300 Dabrowa Gornicza (PL)
(72) Inventor: Borowka, Maciej, Katowice (PL); Widlok, Maciej, Tychy (PL); Dziekan, Wojciech, Mokrus (PL)
(74) Representative: Wroblewski, Marcin Jan

(57) **Abstract**

A system (1) for controlling a smart home, comprising at least one base station (11) provided with a user identification system (116), at least one satellite station (12), at least one environmental sensor (15), at least one actuator (16), also comprising at least one preference identification module (13) and at least one automation mechanism module (14), which modules (13,14) are adjusted to autonomously identify the preferences of the user (17) and autonomously control the smart home. A method (2) for controlling a smart home with the use of the system (1), and a distributed computer system comprising the system (1) along with a computer program implementing the method (2).

## Description

### Technical Field

The object of the invention is a system for controlling a smart home and a method for controlling a smart home. The proposed system is autonomous, and it has functions of recognising the preferences of the user.

The invention relates to the field of building automation, smart home systems with elements of artificial intelligence.

### Prior Art

Devices for a smart home are known from prior art. The existing solutions offer many functions for the automation of processes occurring in a building in interaction with the user, such as, e.g. control of heating, air humidification, control of air conditioning, control of window blinds, activation and deactivation of lighting as well as adjustment of its intensity, and many others. These systems often require complicated programming and configuration. These actions are difficult and time-consuming for an average user. Moreover, in many cases smart home systems are not adjusted to the individual preferences of specific users, which leads to their underutilisation, and thus losses in resources in the form of electrical energy and losing the comfort of users in the rooms.

The main problem faced by the users due to the necessity to manually program automation in smart homes is the complexity of the process as well as the lack of knowledge and time for its implementation. Even advanced users may encounter difficulties when identifying and programming all the possible scenarios which contribute to optimal functioning of a smart home system.

Another problem is the inability of the existing smart home systems to automatically identify the users' individual preferences, which leads to a necessity to create general scenarios for controlling elements of the system, which are not adjusted to the needs of every person using the smart home.

As a result, the users may feel discomfort, since the system is unable to adapt to their changing needs and behaviours. In addition, commercially available smart home systems do not offer dynamic learning functions, which means that they are unable to spontaneously update the automation based on the changing preferences of the users. Therefore, the users must input changes in the system configuration by themselves, which may be cumbersome, especially for people unfamiliar with the technology.

It is therefore desirable to create a solution in the form of an autonomous system for controlling a smart home, capable of adaptive recognition of the users' preferences and dynamic adjustment of the automation.

### Summary

The object of the invention is a system for controlling a smart home, comprising at least one base station provided with a user identification system, at least one satellite station, at least one environmental sensor and at least one actuator. This system comprises at least one preference identification module and at least one automation mechanism module, which modules are adjusted to autonomously identify the preferences of the user and autonomously control the smart home. The system allows the users to more fully utilise the capabilities of the smart home technology, increasing comfort, energy efficiency and safety in smart homes. The purpose of the present invention is to create an innovative autonomous system for controlling a smart home, which would be able to identify the users' individual preferences and dynamically adjust automations. The invention constitutes an answer to the existing problems related to the necessity to manually program and configure smart home systems, as well as the lack of adjustment to the needs of every person using the smart home.

The invention solves the problem of considerable simplification of the complexity of an automation programming process by the introduction of an autonomous learning function. The system analyses contextual data collected from environmental sensors and records changes in the settings of devices made by identified users. It thereby learns the individual preferences of each user and the optimal conditions for various actuators, such as lighting, window blinds or heating.

Preferably, the system is adjusted to cooperate with a mobile device providing the ability to identify the presence of a user in the rooms of the smart home.

Preferably, at least one environmental sensor used in the system is connected to at least one base station or at least one satellite station, and it provides the ability to identify the presence of a user in the rooms of the smart home.

Preferably, at least one environmental sensor used in the system constitutes a camera with a user recognition function.

Preferably, at least one satellite station used in the system is contained inside an in-wall module.

Preferably, each of the base stations of the system comprises a base station power supply, a base station microprocessor, base station memory, a base station near-field network interface and a base station wireless network interface.

Preferably, each of the satellite stations of the system comprises a satellite station power supply, a satellite station microprocessor, satellite station memory, a satellite station near-field network interface, a satellite station wireless network interface and a satellite station actuating module.

The object of the invention is also a method for controlling a smart home, in which method the statuses of the actuators and the environmental sensors are read in sequence, followed by identification of the user along with their location. In the next step, the preferences of the user are determined while taking into account the time context, and subsequently an automation template is created, and the created automation template is handed over for the user's assessment. When the assessment is positive, the automation template is transmitted to a base station, followed by activation of the automation template. When the assessment of the proposed automation is negative, a query is generated regarding the deletion of the automation template, and once the deletion has been confirmed, the automation template is deleted with simultaneous transmission of an opinion about it to the preference identification module. Instead of being removed at once, the template may undergo correction in interaction with the user. In this case, once the correction has been made, the corrected automation template is transmitted to the base station, and the corrected automation template is activated. This is followed by returning to the first step of the method. The method based on the invention allows for dynamic adjustment of automation based on an analysis of the collected data. On the basis of the method, the smart home system is capable of creating, updating and deleting automation templates based on the recognised preferences of users, using elements of artificial intelligence. Due to this, the automations may be better adjusted to the needs of the inhabitants of the smart home.

Preferably, in the method according to the invention, an automation template includes at least data on the amount, type and parameters of the actuators.

Preferably, in the method according to the invention, an automation template is assigned to a specific room, and it comprises the preferences of one or more users.

Preferably, in the method according to the invention, identification of the user is achieved in cooperation with a mobile device.

Preferably, in the method according to the invention, identification of the user is achieved in cooperation with an environmental sensor, in particular a camera.

The object of the invention is also a distributed computer system comprising the system according to the invention adjusted to implement the method according to the invention, and a computer program comprising instructions which, once this program has been executed by the distributed computer system according to the invention, cause the distributed computer system to perform the steps of the method according to the invention.

The object of the invention is also a computer-readable data storage medium comprising instructions, which once executed by the distributed computer system according to the invention cause the distributed computer system to perform the steps of the method according to the invention.

### Advantages of the Invention

The invention results in increasing the living comfort of the users of intelligent buildings, by adjusting automation to the individual preferences and the changing needs.

The application of the invention results in improving energy efficiency, since the system according to the invention is capable of optimally controlling lighting, window blinds, heating or air conditioning, according to the needs and behaviours of the users.

Moreover, increased safety is achieved due to the ability of the system to recognise and respond to unexpected situations, and to the use of advanced functions, such as identification of users.

The invention is advantageous in that it lowers the technological barrier for the users, since the system according to the invention does not require complicated programming and configuration. The users may take full advantage of the scope of the abilities of the smart home technology regardless of their level of expertise.

The invention results in saving time and effort, since the system according to the invention learns spontaneously and adjusts automation, eliminating the need to continuously monitor and update the settings by the users.

### Drawing Description

The object of the invention is presented in embodiments in the drawing, in which:
Fig. 1 presents a block diagram of the system according to the invention;
Fig. 2 presents a block diagram of a sample base station used in the system according to the invention;
Fig. 3 presents a block diagram of a sample satellite station used in the system according to the invention;
Fig. 4 presents a depiction of the method according to the invention.

### Notation and nomenclature

Certain parts of the detailed description which is provided below are presented as part of procedures, data processing steps or other representations of symbolic operations on bit data, which can be performed in computer memory. Therefore, the logical steps are performed by the computer, which requires physical manipulation of physical quantities. Usually, these quantities take on the form of electrical or magnetic signals, suitable for storage, transmission, connection, comparison, or for other ways of manipulating data in a computer system. Due to their widespread use, these data are referred to as signals, time series, bits, packages, messages, values, elements, symbols, signs, expressions, numbers and the like. In addition, all of these terms or those similar to them should be identified with their corresponding physical quantities, and they are merely convenient terms for these physical quantities. Terms such as "processing" or "creating" or "transmitting" or "executing" or "determining" or "detecting" or "receiving" or "selecting" or "calculating" or "generating" or the like refer to the actions and processes of a computer system which manipulates and converts the data represented as physical (electronic) quantities in computer registers and memories into different data, similarly represented as physical quantities in memories or registers or other information storages. A computer-readable medium (memory), as defined in the present document, can usually be non-volatile and/or comprise a non-volatile device. In this context, a non-volatile memory storage medium may comprise a device which can be material, which means that the device has a specific physical form, although this device may change its physical state. Therefore, for example, the term non-volatile refers to a device which remains material, although it changes its state.

### Embodiments of the Invention

### Embodiment 1

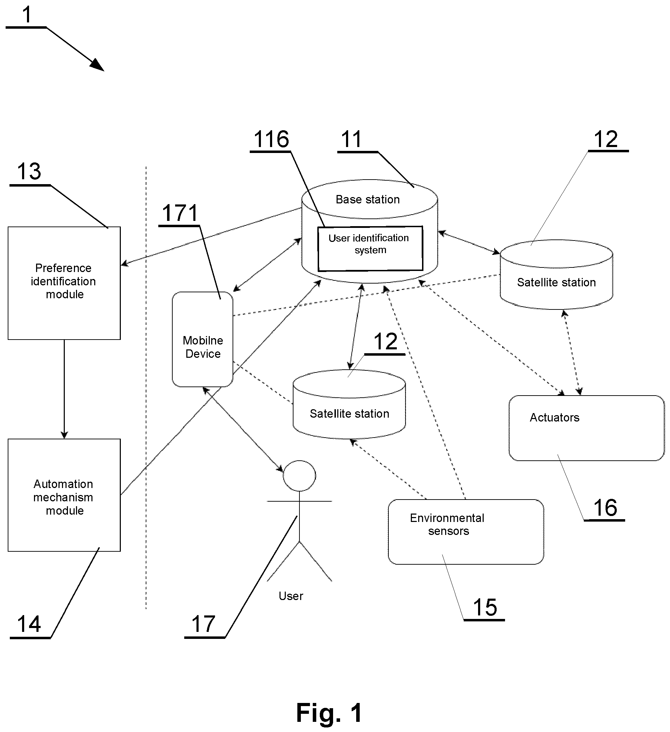

Fig. 1 presents a sample system 1 for controlling a smart home. This system comprises one base station 11 provided with a user identification system 116. The user identification system 116 has the form of a wall-mounted device, present in each room of the smart home, on the display of which it is possible to manually select the user of the system 1 among predefined users 17.

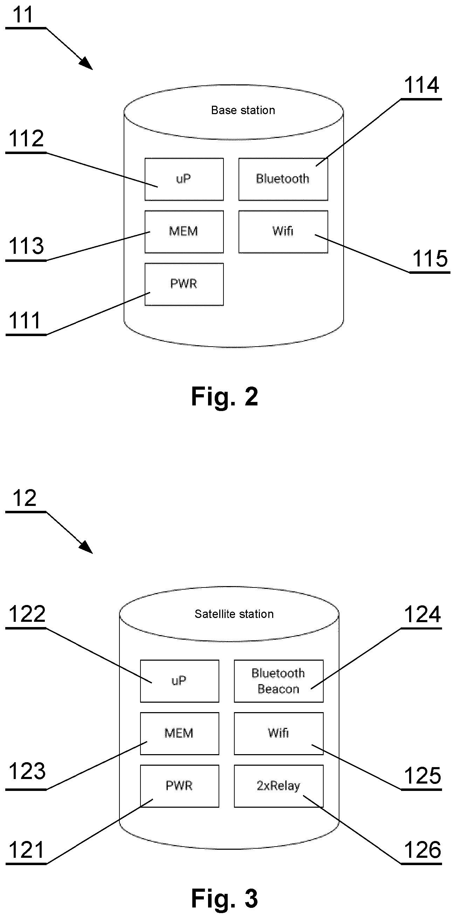

A base station 11 of the system 1 illustrated schematically in Fig. 2 in the form of a central unit of the smart home comprises a base station power supply 111 in the form of a direct voltage source powered by the power grid of the smart home, a base station microprocessor 112, base station memory 113 and a base station near-field network interface 114, having the form of a Bluetooth module. The base station 11 also comprises a base station wireless network interface 115 in the form of a WIFI module.

The system 1 comprises two satellite stations 12 illustrated schematically in Fig. 3, having the form of modules placed inside in-wall boxes in a room of the smart home. Each of the satellite stations 12 comprises a satellite station power supply 121 in the form of a direct voltage source powered from the power grid of the smart home, a satellite station microprocessor 122, satellite station memory 123, a satellite station near-field network interface 124 in the form of a Bluetooth Beacon module, and a satellite station wireless network interface 125 in the form of a WIFI module. The satellite station actuating module 126, being an element of each of the satellite stations 12, has the form of an assembly of two relays capable of controlling the devices of the smart home in an on/off mode and enabling control of lighting as well as window blinds within a range of 0-100% in a given room, in which a given satellite station 12 is installed.

The central unit of the smart home 11 controls satellite stations 12 placed in in-wall boxes, communicating with them via a base station wireless network interface 115 (WIFI), and it enables integration with wired and wireless sensors and actuators. It allows for control of the lighting, window blinds, garage doors, thermostatic heads and air conditioning controllers.

The system 1 comprises an assembly of environmental sensors 15 which collect data on temperature, humidity, lighting intensity and motion, allowing for precise adjustment of the settings of the system 1 to the existing environmental conditions. In each of the rooms in which satellite stations 12 are installed, the system 1 comprises actuators 16 in the form of lighting lamps, window blinds and a television set. The system 1 comprises a preference identification module 13, which is responsible for analysing the data collected from the environmental sensors 15 and events related to the actions of the users 17, in order to determine their preferences. The preference identification module 13 takes into account the time context, including the time, day of the week and environmental parameters, such as temperature, humidity or light intensity, and stores these data as a basis for automation templates 20. The preference identification module 13 determines the preferences of each user 17, such as the level of lighting, the settings of window blinds or the temperature, as well as turning the television set on/off.

The system 1 comprises an automation mechanism module 14, which along with the preference identification module 13 are adjusted to autonomously identify the preferences of the user 17 and autonomously control the smart home. The automation mechanism module 14 analyses the results obtained by the preference identification module 13 and creates, updates or deletes the respective automation templates 20 for the base station 12, in this case the central unit of the smart home. Due to this, the system 1 adapts to the evolving needs and preferences of the users 17, providing optimal conditions in each room.

### Embodiment 2

A system 1 like in embodiment 1, where instead of identification of the user 17 performed by selection of the user on the display of a device placed in each room, it is adjusted to cooperate with a mobile device 171 in the form of a mobile telephone, a tablet or a smartwatch. The mobile device 171 communicates with the satellite station 12 of a given room using a Bluetooth module with the Beacon function, providing the ability to identify the presence of the user 17 in a given room of the smart home. Due to this, the central unit of the smart home 11 may adjust system settings to the individual needs of every person, which translates into greater comfort of usage. Moreover, the system has two base stations 11 installed on two different storeys of the house, each of the base stations 11 serving five separate rooms, in each of which there is an installed satellite station 12. The satellite stations are installed in outer electrical sockets, and some of them in in-wall boxes.

### Embodiment 3

A system like in embodiment 1, where one of the environmental sensors 15 constitutes a camera with a user 17 recognition function, which replaces identification of the user 17 performed by selecting the user on the display of a device placed in each room. The system has one base station 11 and twelve satellite stations 12 connected to this base station.

### Embodiment 4

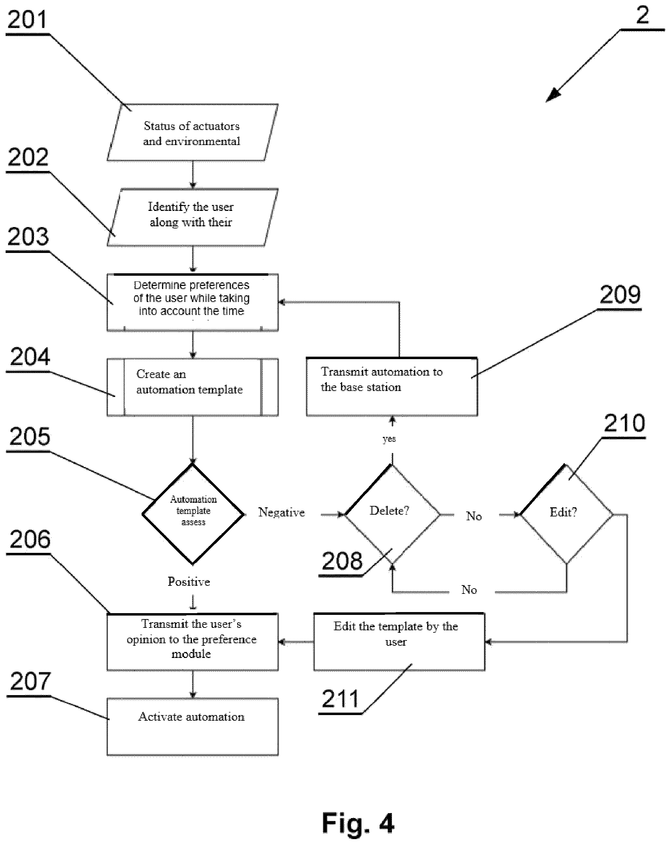

Fig. 4 illustrates schematically a method 2 for controlling a smart home. The method 2 comprises the following consecutive steps.

The status of the actuators 16 and environmental sensors 15 is read 201, and subsequently the user 17 is identified 202 along with their location using any method described in embodiments 1-3. The preferences of the user 17 are determined 203 in sequence, taking into account the time context, which means the day of the week and the time when the specified events occurred in the room. These events are control actions performed by the user, such as turning the lighting on/off, controlling window blinds, turning the television set on/off, determining the temperature in a given room.

Based on the preferences of the user 17 collected for a certain time period, e.g. several consecutive days, an automation template 20 is created 204, which template is handed over 205 to be assessed by the user 17. When the assessment of the user 17 is positive, the automation template 20 is transmitted 206 to a base station 12, followed by activation 207 of the automation template 20. When the assessment is negative, a query 208 is generated regarding the deletion of the automation template 20, and once the deletion has been confirmed, the automation template 20 is deleted 209 with simultaneous transmission of an opinion about it to the preference identification module 13.

Alternatively, the automation template 20 may undergo correction 210, 211 in interaction with the user 17, and subsequently the corrected automation template 20 is transmitted 206 to the base station 12 and activated 207 in sequence. The end of the procedure described in this manner is followed by returning to the first step of the method 201.

The automation template 20 comprises data on the number, type and parameters of the actuators 16 listed in embodiments 1-3. The template comprises a timetable based on days of the week and hours, comprising a pattern of turning the actuators 16 on/off and setting their operational parameters for a given room. The automation template 20 is assigned to a specific room, and it comprises the preferences of, e.g. five users 17.

Due to cooperation of all the components, the system 1 using the method 2 offers an integrated, autonomous solution, which eliminates the need to manually program the central unit of the smart home 11. The system 1 learns the preferences of the users 17; it dynamically adapts to their needs and automatically creates proper scenarios of actions based on the automation templates 20, providing comfort and convenience of use. As a result, the users 17 take full advantage of the abilities of the smart home, regardless of their level of technological expertise. Long-term collection of data and continuous learning of the system 1 using the method 2 allow for increasing the precision of matching the preferences, which leads to optimising the operation of the system 1 and saving energy.

### Description of the operation of a smart home provided with the system according to the invention using the method according to the invention

The user 17 has a house, which is provided with lighting (of the on/off type, dimmers, colours), window blinds or louvres, heaters, air conditioning and a television set. All these devices constitute actuators 16. A user 17 without access to the system 1 and the method 2 must control all the actuators 16 manually for comfort of usage, which in a house of 150m2 means performing approximately 50-60 thousand manual control actions, as estimated for a family of four during the year.

The user 17 may add a traditional smart home management system which may control the actuators 16 by a telephone, or program the system manually using the following principle: "if the condition of low intensity of lighting occurs, turn the light on". A traditional system does not recognise users.

When the user 17 uses the system 1 according to the invention and the method 2, nothing happens in the initial days after installation. The user is able to turn off the light, close the window blinds by a mobile application or manually, like in a traditional system for controlling a smart home. In the initial state, the system 1 did not create any automation.

When living in the house, the user 17 uses it, meaning that they turn specific lights on, set their intensity, set certain window blinds at a specific % or colour, set the heating and cooling at a specific level. Using the method 2, the system 1 records events for a specific user and a specific room and associates them with the occurrence of specific environmental parameters-the time, the day of the week, the intensity of light, cloud cover, temperature, humidity, movement. After 7-14 days of repetitions in the recorded events, the system 1 "makes sure" about what means darkness for which user-to turn on the light, which lights they prefer at what time, how they set the window blinds, etc. After this time, the system switches to the next state, meaning that it creates automation templates 20. For example, "if user no. 1 is present in room no. 2 at 18:00-23:00, turn on light A in 50%, light B in blue, turn off light C, turn off light D"

Subsequently, the user 17 uses the house. The system 1 records the consecutive events. With each month, it has more data. It performs an analysis and matches the automation templates 20 more precisely.

### Description of sample automation templates

### First automation template

The users go to sleep-they turn off all the lights, leaving only one with an intensity of 10%; they close 3 specific window blinds so that sunlight would not wake them up in the morning.

After several nights, the system 1 acquires information that certain events occur during sleep. It proposes a first automation template 20 with the following form "After 24:00, turn the lights off, set one light at 10%, close all three window blinds". Once approved by the user, the automation template 20 is executed every night. The user 17 did not have to provide manual control; the system 1 did this for them. The system 1 detected what the user 17 was doing and how often, and changed it to automation.

### Second automation template

The user 17 watches television; the level of sunlight raises (the sun has come out from behind the clouds); the light intensity sensor records over 1200 lux. The user has approached the window and dropped down two out of five window blinds in the room in 50%. Such an event took place three times. The system has detected the pattern and proposed a second automation template 20 for controlling the window blinds: "if user no. 1 is in room no. 1, and the television set is on, and the LUX value exceeds 1200, close two window blinds in 50%"

### Third automation template

The user 17 returns home. They open the gate, activate garden lighting, open the window blinds. The system 1 detects these patterns and proposes a third automation template 20: "Return home, when the light intensity sensor shows 50 lux, open the gate, activate lighting".

### List of references

1-System for controlling a smart home
11-Base station
   111-Base station power supply
   112-Base station microprocessor
   113-Base station memory
   114-Base station near-field network interface
   115-Base station wireless network interface
   116- User identification system
12-Satellite station
   121-Satellite station power supply
   122-Satellite station microprocessor
   123-Satellite station memory
   124-Satellite station near-field network interface
   125-Satellite station wireless network interface
   126-Satellite station actuating module
13-Preference identification module
14-Automation mechanism module
15-Environmental sensors
16-Actuators
17-User
   171-Mobile device
   1711-Mobile device near-field network interface
2-Method for controlling a smart home
   201-211-Consecutive steps of the method for controlling a smart home
20-automation template

## Claims

1. A system (1) for controlling a smart home, comprising:
- at least one base station (11) provided with a user identification system (116),
- at least one satellite station (12),
- at least one environmental sensor (15),
- at least one actuator (16),
**characterised in that** it comprises
- at least one preference identification module (13) and
- at least one automation mechanism module (14),
which modules (13,14) are adjusted to autonomously identify the preferences of the user (17) and autonomously control the smart home.

2. The system according to claim 1, **characterised in that** it is adjusted to cooperate with a mobile device (171) providing the ability to identify the presence of a user in the rooms of the smart home.

3. The system according to claim 1, **characterised in that** at least one environmental sensor (15) is connected to at least one base station (11) or at least one satellite station (12), and it provides the ability to identify the presence of a user in the rooms of the smart home.

4. The system according to claim 3, **characterised in that** at least one environmental sensor (15) constitutes a camera with a user recognition function.

5. The system according to any of the claims from 1 to 4, **characterised in that** at least one satellite station (12) is contained inside an in-wall module.

6. The system according to any of the claims from 1 to 5, **characterised in that** each of the base stations of the system comprises:
- a base station power supply (111),
- a base station microprocessor (112),
- base station memory (113),
- a base station near-field network interface (114),
- a base station wireless network interface (115).

7. The system according to any of the claims from 1 to 6, **characterised in that** each of the satellite stations of the system comprises:
- a satellite station power supply (121),
- a satellite station microprocessor (122),
- satellite station memory (123),
- a satellite station near-field network interface (124),
- a satellite station wireless network interface (125),
- a satellite station actuating module (126).

8. A method (2) for controlling a smart home, comprising the following consecutive steps:
- reading (201) the status of actuators (16) and environmental sensors (15),
- identifying (202) the user (17) along with their location,
- determining (203) the preferences of the user (17) while taking into account the time context;
- creating (204) an automation template (20);
- handing over (205) the automation template (20) to be assessed by the user (17),
- when assessed positively, transmitting (206) the automation template (20) to the base station (12), and subsequently
- activating (207) the automation template (20),
- when assessed negatively, generating a query (208) about deletion of the automation template (20), and upon approval of the deletion,
- deleting (209) the automation template (20) with simultaneous transmission of an opinion about it to the preference identification module (13),
or
- correcting (210,211) the automation template (20) in interaction with the user (17)
and subsequently
- transmitting (206) the corrected automation template (20) to the base station (12), and subsequently
- activating (207) the automation template (20),
- returning to the first step of the method (201).

9. The method according to claim 8, **characterised in that** the automation template (20) includes at least data on the amount, type and parameters of the actuators (16).

10. The method according to claim 9, **characterised in that** the automation template (20) is assigned to a specific room, and it comprises the preferences of one or more users (17).

11. The method according to any of the claims from 8 to 10, **characterised in that** identification of the user (17) is achieved in cooperation with a mobile device (171).

12. The method according to any of the claims from 8 to 10, **characterised in that** identification of the user (17) is achieved in cooperation with an environmental sensor (15), in particular a camera.

13. A distributed computer system comprising the system according to any of the claims from 1 to 7, adjusted to implement the method according to any of the claims from 8 to 12.

14. A computer program comprising instructions, which once this program has been executed by the distributed computer system according to claim 13 cause the distributed computer system to perform the steps of the method according to any of the claims from 8 to 12.

15. A computer-readable data storage medium comprising instructions, which once executed by the distributed computer system according to claim 13 cause the distributed computer system to perform the steps of the method according to any of the claims from 8 to 12.
